# EUROPÄISCHE PATENTSCHRIFT

(11) **EP 1 055 107 B1**
(45) Veröffentlichungstag und Bekanntmachung des Hinweises auf die Patenterteilung: **29.05.2002**
(21) Anmeldenummer: 99908764.6
(22) Anmeldetag: 03.02.1999
(51) Int. Cl.: G01M 15/00

(54) **VERFAHREN ZUR AUSWERTUNG VON KENNWERTEN PIEZO-MECHANISCHER SYSTEME**
METHOD FOR EVALUATING CHARACTERISTIC VALUES OF PIEZO-MECHANICAL SYSTEMS
PROCEDE D'EVALUATION DES CARACTERISTIQUES DE SYSTEMES PIEZO-MECANIQUES

(30) Priorität: 03.02.1998 DE 19804196
(43) Veröffentlichungstag der Anmeldung: 29.11.2000
(73) Patentinhaber: SIEMENS AKTIENGESELLSCHAFT, 80333 München (DE)
(72) Erfinder: MOCK, Randolf, D-81739 München (DE); CHEMISKY, Eric, D-85540 Haar (DE); KAPPEL, Andreas, D-85649 Brunnthal (DE)
(86) Internationale Anmeldenummer: DE9900284
(87) Internationale Veröffentlichungsnummer: WO9940408

(56) Entgegenhaltungen:
- EP-A- 0 753 717
- EP-A- 0 849 574
- WO-A-90/11207
- WO-A-94/08214
- WO-A-94/21983
- DE-A- 4 324 692
- DATABASE WPI Section EI, Week 8631 Derwent Publications Ltd., London, GB; Class S03, AN 86-203670 XP002102765 & SU 1 201 750 A (VOVK I V) , 30. Dezember 1985

## Beschreibung

Die Erfindung betrifft ein Verfahren zur Auswertung von elektrischen Kennwerten eines gekoppelten piezo-mechanischen Systems.

Zur Steuerung mechanischer Bewegungen werden verstärkt Piezoelemente eingesetzt, beispielsweise in Kraftstoffeinspritzern.
Das gekoppelte System aus einem Piezoelement, beispielsweise einer Piezokeramik, und einer damit verbundenen, mechanisch bewegbaren Vorrichtung wird im folgenden als piezo-mechanisches System bezeichnet. Das piezo-mechanische System kann dabei zusätzlich durch eine andere Wirkweise beeinflußt werden, beispielsweise mittels einer hydraulischen Vorrichtung oder durch einen elektromagnetisch angetriebenen Motor. Gegenüber einem derzeitig hauptsächlich eingesetzten elektromagnetischen Antrieb wird die Kraftübertragung vom Piezoelement zu den mechanischen bewegten Teilen nicht indirekt über ein Kraftfeld (z. B. ein Magnetfeld), sondern direkt über eine mechanische Kopplung (Hydraulik, Stößel u. ä.) vorgenommen.
Ein weiterer Unterschied ist, daß das Piezoelement als mechanisch-elektrischer Wandler sowohl Teil des mechanischen, als auch Teil des elektrischen Wirkungkreises bzw. Teilsystems ist. Der Kopplungseffekt zwischen mechanischem und elektrischem Teilsystem ist bei einem Piezoelement - anders als beispielsweise beim elektromagnetisch angetriebenen Aktor - näherungsweise linear (bzw. relativ einfach beschreibbaren Zusammenhängen folgend). Man hat daher bei einem piezo-mechanischen System eine direkte Rückwirkung des mechanischen Teilsystems auf das elektrische Teilsystem. Dies bedeutet, daß Veränderung eines mechanischen Parameters (z. B. durch Verschleiß oder Alterung) die mechanische Steifigkeit von Komponenten verändern, so daß die Gegenkraft, die das Piezoelement erfährt, hierdurch unmittelbar beeinflußt wird.
Es ist bekannt, daß sich der Impedanzverlauf des Piezoelementes als Ganzes, sowie im besonderen die Lage von Impedanzmaxima und -minima ändert, wenn eine mechanische Einflußgröße (beispielsweise der Druck auf das Piezoelement) modifiziert wird.

Aufgabe der vorliegenden Erfindung ist es, die Eigenschaften eines Piezoelementes zur Diagnose eines piezo-mechanischen Systems zu nutzen.

Diese Aufgabe wird durch die Merkmale des Anspruchs 1 gelöst.

Für die Lösung der Aufgabe wird die Tatsache ausgenutzt, daß der Zustand des mechanischen Teilsystems durch die mechanisch-elektrische Kopplung via Piezoelement die elektrischen Kennwerte des Piezoelementes (im folgenden das Piezo-Signal genannt) in charakteristischer Weise beeinflußt. Durch die Messung und Bewertung elektrischer Kennwerte des Piezoelements ist eine Diagnose, d.h. die Erkennung von Funktionsstörungen und Funktionsausfällen, der mechanischen Funktion des piezo-mechanischen Systems möglich.
Neben dem Zustand des mechanischen Teilsystems kann durch die elektrischen Kennwerte auch derjenige des elektrischen Teilsystems (inkl. Piezoelement) diagnostiziert werden. So führen beispielsweise Kurz- bzw. Feinschlüsse im Piezoelement aufgrund der so veränderten Impedanz des Piezoelementes zu veränderten Schaltzeiten des Systems, die sich im zeitabhängigen Verhalten elektrischer Kenngrößen während der Ein- und Ausschaltphase auf verschiedene Weise bemerkbar machen.

Eine Diagnosemöglichkeit ist beispielsweise von großem Vorteil für den Automobilbereich, bei dem die gesetzliche Regelung "OBD 2" vorschreibt, daß alle Aggregate eines Automobils, die für dessen Sicherheit und Umweltverträglichkeit relevant sind, während des Betriebs eines Fahrzeugs auf ihre ordnungsgemäße Funktion hin überwacht werden müssen. Dies trifft in besonderem Maße auf Kraftstoffeinspritzer zu, deren Zustand sowohl den Schadstoffausstoß, als auch den zuverlässigen Betrieb eines Motors unmittelbar beeinflußt.
Ein weiters Beispiel ist der Flugzeugbau, bei dem die mechanische Bewegung von Antrieben, beispielsweise des Höhen- und Seitenruders, durch elektrische Signale bestimmt wird (sog. "Fly-By-Wire"). Dabei existieren Flugzeugkonstruktionen, die ohne eine permanente Steuerung und Überwachung der mechanischen Steuerteile nicht flugfähig sind. Funktionsstörungen oder Schäden an einem mechanischen Antrieb, beispielsweise einem Linearantrieb mit Piezoaktor, müssen daher frühzeitig erkannt werden.

Anhand von Ausführungsbeispielen wird im folgenden die Erfindung näher erläutert.
- Figur 1: zeigt schematisch eine Möglichkeit zur Diagnose eines piezo-mechanischen Systems mittels Schwellwertabfrage des Piezo-Signals,
- Figur 2: zeigt schematisch eine weitere Möglichkeit zur Diagnose eines piezo-mechanischen Systems mittels Schwellwertabfrage oder Extremwertabfrage,
- Figur 3: zeigt schematisch eine Möglichkeit zur Diagnose eines piezo-mechanischen Systems mittels Fourieranalyse,
- Figur 4: zeigt schematisch eine Möglichkeit zur Diagnose eines piezo-mechanischen Systems mittels zeitlicher Ableitung des Piezo-Signals und anschließender Anwendung eines Schmitt-Triggers,
- Figur 5: zeigt die Wirkweise einer aktiven Möglichkeit zur Diagnose eines piezo-mechanischen Systems.

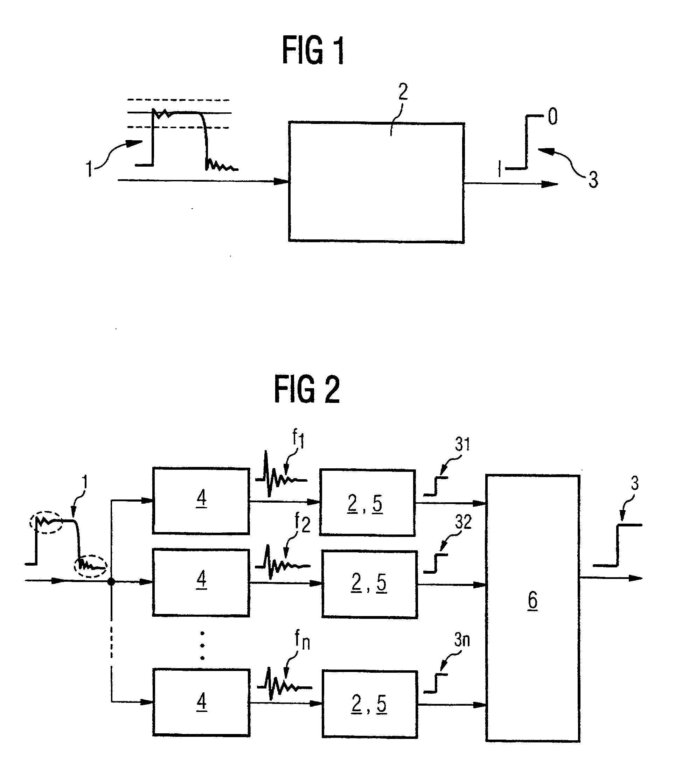

Figur 1 zeigt schematisch ein Verfahren zur Diagnose eines piezo-mechanischen Systems mittels Abfrage eines Schwellwertes eines Piezo-Signals 1, das beispielsweise ein Spannungssignal oder ein Stromsignal sein kann. Der Ablauf des Verfahrens ist als Flußdiagramm dargestellt, das von links nach rechts durchlaufen wird.
Es wird angenommen, daß zur Auslenkung des Piezoelementes ein Rechtecksignal an dieses angelegt wird, beispielsweise zum Ein- bzw. Ausschalten eines Kraftstoffinjektors. Durch die Kopplung mit dem am Piezoelement befestigten mechanischen Teilsystem wird dem von außen aufgegebenen Rechtecksignal ein elektrisches Zusatzsignal überlagert. Am Piezoelement wird insgesamt ein Piezo-Signal 1 gemessen. Im Piezo-Signal 1 ist die Antwort des gesamten gekoppelten piezo-mechanischen Systems auf das angelegte Rechecksignal enthalten.
An dem Piezo-Signal 1 wird sodann eine Schwellwertabfrage 2 durchgeführt, d.h. es wird geprüft, ob der Wert des Piezo-Signals 1
- einen bestimmbaren Schwellwert überschreitet, oder
- einen bestimmbaren Schwellwert unterschreitet, oder
- innerhalb eines Bereichs, der durch zwei verschiedene Schwellwerte begrenzt ist, (der "Bandbreite") liegt.
Die Schwellwertabfrage 2 umfaßt damit auch die Prüfung, ob bei Vorhandensein mehrerer Schwellwerte der Wert des Piezo-Signals 1 innerhalb eines bestimmten Satzes von Schwellwerten liegt. Weiterhin umfaßt die Schwellwertabfrage 2 auch die Abfrage eines Vorhandenseins eines Signals (beispielsweise durch Schwellwert 0).
Die Einstellung eines Schwellwertes beeinhaltet eine Beurteilung über den Zustand des piezo-mechanischen Systems. Auf der Basis der Schwellwertabfrage 2 wird ein Ausgangssignal 3 ausgegeben, das den Zustand des piezo-mechanischen Systems anzeigt.
In dieser Figur wird das Ausgangssignal 3 verändert, wenn der Wert des Piezo-Signals 1 eine Bandbreite (hier durch gestrichelt eingezeichnete Geraden begrenzt) um das Maximum des ungestörten Rechtecksignals (durchgezogene Gerade) verläßt. Liegt das Piezo-Signal 1 innerhalb der vorgegebenen Bandbreite, so liegt ein bestimmter Zustand des Ausgangssignals 3, beispielsweise "I" oder "aus", vor. Verläßt hingegen das Piezo-Signal 1 die vorgegebene Bandbreite, so wird der Zustand des Ausgangsasignals 3 verändert (beispielsweise auf "O" bzw. "Ein").
Vorteilhafterweise wird die Bandbreite so eingestellt, daß diese bei ordnungsgemäßer Funktion des piezo-mechanischen Systems nicht verlassen wird ("Sollbereich"). Ein Verlassen des Sollbereichs deutet dann auf eine Funktionsstörung hin.
Durch ein solches Verfahren wird also der Zustand des gesamten gekoppelten piezo-mechanischen Systems auf eine einfache Weise diagnostiziert.

Es ist vorteilhaft, wenn mehrere Schwellwerte zur Diagnose eingesetzt werden, weil dadurch mittels Nutzung mehrerer Signalzustände des Ausgangssignals 3 der Grad der Funktionsstörung in Abhängigkeit von der Abweichung des Piezo-Signals 1 vom Sollbereich angezeigt werden kann (beispielsweise eine Diagnose "leichte Störung" bei einer geringen Abweichung vom Sollbereich und eine Diagnose "schwere Störung" bei einem Schwellwert, der vom Sollbereich weiter entfernt ist). Dadurch kann eine Funktionsstörung differenzierter bewertet werden.

Figur 2 zeigt schematisch ein weiteres Verfahren zur Diagnose eines piezo-mechanischen Systems durch Schwellwertabfrage 2 eines Piezo-Signals 1. Der Ablauf des Verfahrens ist als Flußdiagramm dargestellt, das von links nach rechts durchlaufen wird.
Aus dem Piezo-Signal 1 werden durch Frequenzfilterung 4 n (n ≥ 1) frequenzgefilterte Signale f1 ... fn jeweils durch eine Schwellwertabfrage 2 bewertet, die jeweils den Zustand eines Signals 31 ... 3n ändert. Die Frequenzfilterung 4 ist dabei vorteilhafterweise in Form eines Bandpaß- oder Nadelfilters realisiert.
Die Anwendung einer Frequenzfilterung 4 besitzt gegenüber der Schwellwertabfrage 2 des Piezo-Signals 1 (wie in Figur 1) den Vorteil, daß die aufgespaltenen Teilsignale f1 ... fn charakteristisch für das Verhalten einzelner mechanischer Komponenten eines komplexen piezo-mechanischen Systems sind. So kann beispielsweise die Abweichung eines frequenzgefilterten Signals f1 ... fn von der jeweiligen Bandbreite auf die Funktionsstörung einer bestimmten mechanischen Komponente hindeuten.
Eines oder mehrere der mit Hilfe der Schwellwertabfrage 2 erhaltenen Signale 31 ... 3n werden sodann mit Hilfe einer separaten Auswerteeinheit 6 erneut bewertet. Die Auswerteeinheit 6 kann das Ausgangssignal 3 vorgeben, wenn eine bestimmte Kombination von Signalen 31 ... 3n vorliegt, beispielsweise bei gleichzeitiger Überschreitung der Schwellwerte des 1. (f1), 2. (f2), 5. (f5) und n-ten (fn) frequenzaufgespaltenen Signals. Dies ist vorteilhaft, wenn mehrere der frequenzaufgespaltenen Signale f1 ... fn auf die gleiche Funktionsstörung hindeuten.
Die Auswerteeinheit 6 ist vorteilhafterweise durch einen digitalen Signalprozessor (DSP) realisiert, aber auch eine geeignete analoge oder aus digitalen Standardelementen zusammengesetzte Folgeschaltung ist geeignet.
Es ist auch möglich, zusätzlich zu den frequenzgefilterten Signalen f1 ... fn das ursprüngliche Piezo-Signal 1 auszuwerten.

Die Schwellwertabfrage läßt sich auch bei mindestens einem der auszuwertenden Signale f1 ... fn durch eine Extremwertabfrage 5, d.h. durch eine Bestimmung der lokalen Minima und Maxima, ersetzen. Da die frequenzgefilterten Signale f1 ... fn im allgemeinen in Form einer Sinusschwingung vorliegen, läßt sich durch eine Extremwertabfrage 5 Frequenz und Dämpfung dieser Signale bestimmen. Auch hierbei wird jeweils ein Sollwertbereich für die Werte von Frequenz und Dämpfung vorgegeben, dessen Verlassen durch die Zustandsänderung jeweils eines Signals 31 ... 3n angezeigt wird. Liegt das Piezo-Signal 1 in Form einer regelmäßigen Schwingung vor, so kann auch das Piezo-Signal 1 einer Extremwertabfrage 5 unterworfen werden.

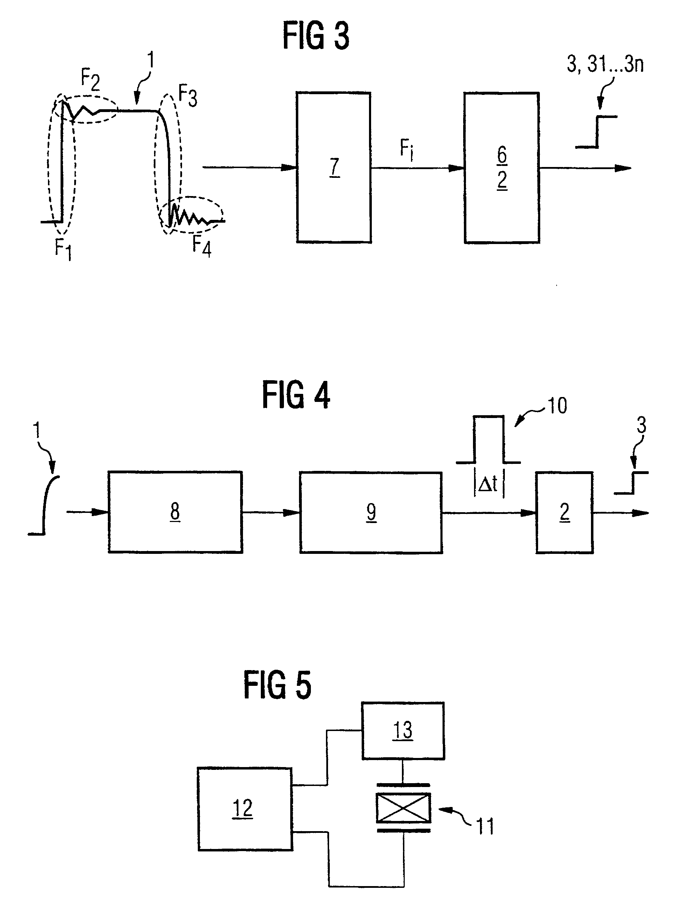

In Figur 3 ist schematisch die Bewertung eines Piezo-Signals 1 mittels Fourieranalyse 7, dargestellt. Der Ablauf des Verfahrens ist als Flußdiagramm dargestellt, das von links nach rechts durchlaufen wird. Das Piezo-Signal 1 wird zunächst durch eine Fourier-Analyse 7 verarbeitet. Die Fourier-Analyse 7 ist dabei vorteilhafterweise durch eine schnelle Fouriertransformation (sog. "Fast Fourier Transfomation" (FFT)) realisiert. Durch die Fourier-analyse 7 erhält man beispielsweise im Piezo-Signal 1 enthaltene Frequenzen, Frequenzverschiebungen, Amplituden und/oder Halbwertsbreiten. Dieser Satz der von der Fourier-Analyse 7 ausgegebenen Parameter wird als Fi bezeichnet, mit den einzelnen Parametern F1 .... Fn (n ≥ 1). Die Verarbeitung mittels Fourieranalyse 7 benötigt keine Frequenzfilterung 4, sie enthält aber einen Mechanismus zur Bestimmung des Parametersatzes Fi aus dem Fourierspektrum.

Zur Verdeutlichung sind am Piezo-Signal 1 schematisch vier Bereiche gestrichelt markiert, in denen die Fourier-Analyse 7 charakteristische Frequenzen F1 ... F4 erkennen könnte.
Die Werte des Parametersatzes Fi können in einem weiteren Schritt durch eine Auswerteeinheit 6 (etwa durch einen einfachen Auswertealgorithmus per DSP) weiter bewertet, wobei durch die Auswerteeinheit 6 ein Ausgangssignal 3, ggf. mit mehreren Signalzusständen, gesetzt wird.
Auch können die Werte einer oder mehrerer Parameter F1 .... Fn des Parametersatzes Fi jeweils durch eine Schwellwertabfrage 2 bewertet werden (in dieser Figur zusammenfassend durch einen Bewertungsschritt dargestellt). Die dadurch gewonnenen Signale 31 ... 3n können durch eine Auswerteeinheit 6, ggf. zusammen mit direkt aus der Fourier-Analyse gewonnenen Werten des Parametersatzes Fi, weiter bewertet werden, wobei durch die Auswerteeinheit 6 ein Ausgangssignal 3, ggf. mit mehreren Signalzusständen, gesetzt wird (nicht dargestellt.

In Figur 4 ist schematisch die Bewertung eines Piezo-Signals 1 durch zeitliche Ableitung 8 und nachfolgende Anwendung eines Schmitt-Triggers 9 dargestellt. Vom Piezo-Signal 1 ist in dieser Figur nur die ansteigende Flanke dargestellt. Besonders, wenn die zu erwartende Amplitude des Zusatzsignals klein ist gegenüber dem von außen vorgegebenen Signal, mit dem das Piezoelement angesteuert wird, ist eine solche Bearbeitung des Piezo-Signals 1 vorteilhaft. Sinnvoll ist gerade im Fall der hier verwendeten Piezoansteuerung die Bildung der zeitlichen Ableitung, da auf diese Weise die Plateaus des Rechtecksignals herausfallen. Darüber hinaus werden gerade höherfrequente Signalanteile stärker gewichtet (ist U(t) = U₀·exp(iωt), dann ist dU/dt=iωU(t), womit bei konstanter Amplitude von U(t) deren Ableitung - abgesehen von einer Phasenverschiebung von 90° - linear in der Frequenz ist). Ansonsten werden sinusförmige Anteile des Signals in ihrem zeitlichen Verlauf nicht verändert, so daß die gleichen Auswerteverfahren zur Anwendung kommen können, wie sie zuvor im Falle der direkten Signalauswertung dargelegt wurden (Figuren 1-4). Dies würde einer Vorverarbeitung der zu bewertenden Signale 1, f1 ... fn entsprechen.
In diesem Ausführungsbeispiel wird das zeitabgeleitete Signal mit Hilfe eines Schmitt-Triggers 9 weiterverarbeitet, woraus sich ein Signal 10 einer Breite Δt ergibt. Durch Schwellwertabfrage 2 dieser Breite Δt wird der Zustand eines Ausgangssignals 3 festgelegt.

In Figur 5 ist schematisch das Funktionsprinzip eines aktiven Verfahrens zur Diagnose eines piezo-mechanischen Systems als Blockschaltbild aufgetragen.
Ein mit einer mechanischen Vorrichtung verbundenes Piezoelement 11 wird, beispielsweise durch einen Frequenzgenerator 12, mit sinusförmigen Spannungen angesteuert, deren Frequenz über die Zeit verändert wird. Die dabei verwendeten Frequenzen entsprechend vorteilhafterweise den charakteristischen Frequenzen des mechanischen Teilsystems. Da man über die mechanisch-elektrische Kopplung des Piezoelementes 11 eine Rückwirkung auf den Verlauf der elektrischen Impedanz des Piezoelementes hat, beispielsweise über einen Strom- und/oder Spannungsdetektor 13, sieht man die mechanischen Resonanzen als Spitzen im elektrischen Impedanzverlauf. Die Auswertung dieser Impedanzspitzen kann sowohl über den Betrag als auch über die Phase durchgeführt werden.
Eine solche Anordnung kann beispielsweise zum Testen eines piezo-mechanischen Systems verwendet werden, damit die Schwingungseigenschaften des piezo-mechanischen Systems analysiert werden können, oder beispielsweise zur Ermittlung von Resonanzfrequenzen.

Die in den Figuren 1 - 5 dargestellten Diagnoseverfahren können beispielsweise zur Funktionsüberwachung von mit Piezoaktoren ausgestatteten Kraftstoffeinspritzungen eingesetzt werden. Dabei kann beispielsweise ein Piezoelement, beispielsweise eine Piezokeramik, eine Steuernadel, gegebenenfalls über einen Hubverstärker, antreiben.
Bei Benzin-Direkteinspitzungen kann diese Steuernadel beispielsweise die in den Brennraum eines Motors eingespritzte Kraftstoffmenge direkt steuern, indem die Steuernadel die Öffnung zwischen Kraftstoffzufuhr und Brennraum verschließt. Bei Diesel-Direkteinspritzungen (z.B. sog. "Common-Rail"-Einspritzverfahren) kann die Steuernadel beispielsweise ein hydraulisches Ventil steuern, das wiederum eine Einspritzdüsennadel, die die Öffnung zwischen Kraftstoffzufuhr und Brennraum verschließt, führt.
Die aufgeführten Diagnoseverfahren könnten in diesen Fällen beispielsweise einen Verschleiß oder ein Klemmen der Steuernadel oder der Einspritzdüsennadel feststellen oder einen Druckabfall im Druckkreis des hydraulischen Ventils.

## Patentansprüche

1. Verfahren zur Diagnose eines piezo-mechanischen Systems, welches mindestens ein Piezoelement (11) und ein davon angesteuertes mechanisches System enthält, bei dem
ein am Piezoelement (11) abgegriffenes elektrisches Piezo-Signal (1) mit einem das Piezoelement (11) ansteuernden elektrischen Signal verglichen wird, und aus der Abweichung dieser beiden Signale voneinander ein Zustand des piezo-mechanischen Systems bestimmt wird.

2. Verfahren nach Anspruch 1, bei dem
das Piezo-Signal (1) einer Schwellwertabfrage (2) unterworfen wird, aufgrund deren Ergebnis mindestens ein Ausgangssignal (3) verändert werden kann.

3. Verfahren nach Anspruch 1, bei dem
aus dem Piezo-Signal (1) n (n ≥ 1) frequenzgefilterte Signale (f1 ... fn) gewonnen werden, und
bei m (1 ≤ n ≤ n) frequenzgefilterten Signalen (f1... fm) jeweils eine Schwellwertabfrage (2) durchgeführt wird, aufgrund deren Ergebnis jeweils ein ausgegebenes Signal (31 ... 3m) verändert werden kann.

4. Verfahren nach Anspruch 3, bei dem
der Zustand mindestens eines Ausgangssignals (3) mittels einer Auswerteeinheit (6) bestimmt wird, wobei die Auswerteeinheit (6) eine beliebige Kombination von Signalen (31 ... 3n) der Schwellwertabfragen (2) zur Bestimmung des Ausgangssignals (3) heranzieht.

5. Verfahren nach Anspruch 4, bei dem
zusätzlich das Piezo-Signal (1) zur Bestimmung des Ausgangssignals (3) verwendet wird.

6. Verfahren nach einem der Ansprüche 1 bis 5, bei dem
bei mindestens einem zu bewertenden Signal (1, f1 ... fn) statt der Schwellwertabfrage (2) eine Extremwertabfrage (5) durchgeführt wird.

7. Verfahren nach einem der Ansprüche 1 bis 6, bei dem
mindestens eines der zu bewertenden Signale (1, f1 ... fn) nach der Zeit abgeleitet wird.

8. Verfahren nach Anspruch 1, bei dem
das Piezo-Signal (1) einer Fourier-Analyse (7) unterzogen wird und mindestens einer der von der Fourier-Analyse (7) ausgegebenen Werte (Fi) einer Schwellwertabfrage (2) unterworfen wird, aufgrund der der Zustand eines Ausgangssignals (3) verändert werden kann.

9. Verfahren nach Anspruch 8, bei dem
die Fourier-Analyse (7) eine schnelle Fourier-Transformation ist.

10. Verfahren nach Anspruch 1 bei dem
das Piezo-Signal (1) nach der Zeit abgeleitet wird und danach durch einen Schmitt-Trigger (9) verarbeitet wird, wobei aufgrund der Schwellwertabfrage (2) der Breite des sich aus dem Schmitt-Trigger (9) ergebenden Signals (10) der Zustand des Ausgangssignals (3) verändert werden kann.

11. Verfahren nach Anspruch 1, bei dem
das Piezoelement (11) mit einem Spannungssignal angesteuert wird, und der Betrag und/oder die Phase der Spitzen einer elektrischen Impedanz des Piezoelementes (11) gemessen wird, und der Wert dieses Betrags und/oder der Phase zur Diagnose herangezogen wird.

12. Verfahren nach Anspruch 11, bei dem
das Piezoelement (11) mit in zeitlicher Abfolge sinusförmigen Spannungen variabler Frequenz angesteuert wird.

13. Verfahren nach Anspruch 12,
bei dem die Frequenzen der sinusförmigen Spannungen den Resonanzfrequenzen des mechanischen Teilsystems des piezo-mechanischen Systems entsprechen.

14. Verfahren nach einem der Ansprüche 1 bis 13 zur Verwendung in einem Kraftstoff-Enspritzer.

## Claims

1. Method for the diagnosis of a piezo-mechanical system containing at least one piezoelement (11) and a mechanical system driven by the latter, in which an electrical piezo-signal (1) tapped off at the piezoelement (11) is compared with an electrical signal driving the piezoelement (11), and a state of the piezo-mechanical system is determined from the deviation between these two signals.

2. Method according to Claim 1, in which
the piezo-signal (1) is subjected to a threshold value interrogation (2), and at least one output signal (3) can be altered on the basis of the result of the said interrogation.

3. Method according to Claim 1, in which
n (n ≥ 1) frequency-filtered signals (f1...fn) are obtained from the piezo-signal (1), and
a respective threshold value interrogation (2) is carried out for m (1 ≤ m ≤ n) frequency-filtered signals (f1...fm) , and a respective output signal (31...3m) can be altered on the basis of the result of the said interrogation.

4. Method according to Claim 3, in which
the state of at least one output signal (3) is determined by means of an evaluation unit (6), the evaluation unit (6) using an arbitrary combination of signals (31...3n) of the threshold value interrogation (2) for determining the output signal (3).

5. Method according to Claim 4, in which
the piezo-signal (1) is additionally used for determining the output signal (3).

6. Method according to one of Claims 1 to 5, in which
in the case of at least one signal (1, f1... fn) to be assessed, an extreme value interrogation (5) is carried out instead of the threshold value interrogation (2).

7. Method according to one of Claims 1 to 6, in which
at least one of the signals (1, f1... fn to be assessed is differentiated with respect to time.

8. Method according to Claim 1, in which
the piezo-signal (1) is subjected to a Fourier analysis (7) and at least one of the values (Fi) output by the Fourier analysis (7) is subjected to a threshold value interrogation (7), on the basis of which the state of an output signal (3) can be altered.

9. Method according to Claim 8, in which
the Fourier analysis (7) is a fast Fourier transformation.

10. Method according to Claim 1, in which
the piezo-signal (1) is differentiated with respect to time and is then processed by a Schmitt trigger (9), in which case the state of the output signal (3) can be altered on the basis of the threshold value interrogation (2) of the width of the signal (10) resulting from the Schmitt trigger (9).

11. Method according to Claim 1, in which
the piezoelement (11) is driven with a voltage signal, and the magnitude and/or the phase of the spikes of an electrical impedance of the piezoelement (11) are/is measured, and the value of this magnitude and/or of the phase is used for the diagnosis.

12. Method according to Claim 11, in which
the piezoelement (11) is driven with voltages of variable frequency which are sinusoidal in temporal sequence.

13. Method according to Claim 12,
in which the frequencies of the sinusoidal voltages correspond to the resonant frequencies of the mechanical subsystem of the piezo-mechanical system.

14. Method according to Claims 1 to 13 for use in a fuel injector.

## Revendications

1. Procédé destiné au diagnostic d'un système piézo-mécanique, qui comporte au moins un piézo-élément (11) et un système mécanique excité par ce dernier, dans lequel
un piézo-signal électrique (1), prélevé sur le piézo-élément (11), est comparé à un signal électrique, qui excite le piézo-élément (11), et, à partir de la différence entre ces deux signaux, on détermine un état du système piézo-mécanique.

2. Procédé selon la revendication 1 dans lequel
le piézo-signal (1) est soumis à une interrogation de valeur de seuil (2), au moins un signal de sortie (3) pouvant être modifié sur la base du résultat de cette interrogation.

3. Procédé selon la revendication 1 dans lequel
n (n ≥ 1) signaux filtrés en fréquences (f1 ... fn) sont obtenus à partir du piézo-signal (1) et
une interrogation de valeur de seuil (2) est exécutée séparément sur m (1 ≤ m ≤ n) signaux (f1 ... fm), filtrés en fréquences, un signal émis dans chaque cas (31 ... 3m) pouvant être modifié sur la base du résultat de cette interrogation.

4. Procédé selon la revendication 3 dans lequel
l'état d'au moins un signal de sortie (3) est déterminé au moyen d'une unité d'évaluation (6), l'unité d'évaluation (6) faisant appel à une combinaison quelconque de signaux (31 ... 3n) des interrogations de valeur de seuil (2) pour déterminer le signal de sortie (3).

5. Procédé selon la revendication 4 dans lequel
on utilise, en plus, le piézo-signal (1) pour déterminer le signal de sortie (3).

6. Procédé selon l'une des revendications 1 à 5 dans lequel
on exécute, pour au moins un signal à évaluer (1, f1 ... fn), à la place de l'interrogation de valeur de seuil (2), une interrogation de valeur extrême (5).

7. Procédé selon l'une des revendications 1 à 6 dans lequel
au moins l'un des signaux à évaluer (1, f1 ... fn) est obtenu par dérivation par rapport au temps.

8. Procédé selon la revendication 1 dans lequel
le piézo-signal (1) est soumis à une analyse de Fourier (7) et au moins une des valeurs délivrées par l'analyse de Fourier (7) est soumise à une interrogation de valeur de seuil (2), sur la base de laquelle l'état d'un signal de sortie (3) peut être modifié.

9. Procédé selon la revendication 8 dans lequel
l'analyse de Fourier (7) est une transformée rapide de Fourier.

10. Procédé selon la revendication 1 dans lequel
le piézo-signal (1) est soumis à une dérivation par rapport au temps et, ensuite, traité par un circuit basculeur de Schmitt (9), l'état du signal de sortie (3) pouvant être modifié sur la base de l'interrogation de valeur de seuil (2) de la largeur du signal (10), qui sort du circuit basculeur de Schmitt (9).

11. Procédé selon la revendication 1 dans lequel
le piézo-élément (11) est excité par un signal de tension et l'amplitude et/ou la phase des pointes d'une impédance électrique du piézo-élément (11) sont mesurées et la valeur de cette amplitude et/ou de cette phase est mise à profit pour le diagnostic.

12. Procédé selon la revendication 11 dans lequel
le piézo-élément (11) est excité, suivant une séquence temporelle, par des tensions sinusoïdales de fréquences variables.

13. Procédé selon la revendication 12 dans lequel
les fréquences des tensions sinusoïdales correspondent aux fréquences de résonance du sous-système mécanique du système piézo-mécanique.

14. Procédé selon l'une des revendications 1 à 13, mis en oeuvre dans le cadre d'une injection de carburant.
